# EUROPEAN PATENT APPLICATION

(11) **EP 2 136 388 A2**
(43) Date of publication of application: **23.12.2009**
(21) Application number: 09008048.2
(22) Date of filing: 19.06.2009
(51) Int. Cl.: H01J 37/34

(54) **Deposition of Materials**

(30) Priority: 20.06.2008 GB 0811382
(71) Applicant: Mantis Deposition Limited, Thame, Oxfordshire OX9 3BX (GB)
(72) Inventor: Allers, Lars, Chinnor Oxfordshire OX39 4DT (GB); Kean, Alistair, Watlington Oxfordshire, OX49 5LX (GB)
(74) Representative: Downing, Michael Philip

(57) **Abstract**

Sputter deposition can move towards a more commercial scale, by adopting a geometry that is more susceptible to larger scale operation and also by encouraging the production of the necessary charged nanoparticles. The former is assisted by a magnetron comprising a cylindrical target having at least an outer face of the material to be deposited and a hollow interior, and a source of magnetic flux within the hollow interior arranged to present magnetic poles in a direction that is radially outward with respect to the cylindrical target. The source of magnetic flux preferably presents alternating north and south magnetic poles in circumferential bands around the target. The latter is enabled by providing a plasma or electron cloud in the flight path at a later stage where atoms are more likely to have coalesced into nanoparticles. Magnets are able to extend the physical extent of the sputter plasma, allowing electron capture by the nanoparticles that have been generated by the plasma. Accordingly, an apparatus for the production of nanoparticles is disclosed comprising a magnetron within a chamber containing a gas at low pressure, a means for creating a flow of the gas away from the magnetron, and at least one source of magnetic flux located downstream from the magnetron.

## Description

### FIELD OF THE INVENTION

The present invention relates to the deposition of materials.

### BACKGROUND ART

One established method for the deposition of materials is sputter deposition. According to this method, a target composed of the material to be deposited is placed over a magnetron in a chamber containing a low pressure Inert gas such as Argon. A plasma is then created immediately above the target, and high energy collisions with gas ions from the plasma cause the target to (In effect) undergo forced evaporation into the low pressure chamber. The evaporated material is not in thermodynamic equilibrium and will condense onto nearby surfaces, creating a thin film coating. Alternatively, the evaporated atoms can be caused to travel through appropriate conditions to create nanoparticles.

Sputter deposition has not however met with wide commercial acceptance, and (other than in specialist contexts) is primarily a laboratory tool. This Is mainly due to the slow rate of deposition that is achieved, and the difficulty involved in scaling the process up which means that batch sizes are relatively small. These two factors combine to militate against the use of sputtering on an industrial scale.

Sputtering is however useful in the production of a surface film of nanoparticles, by allowing atoms In a stream partially to condense during their flight towards a substrate. This can be encouraged by allowing a slightly elevated gaseous pressure to subsist in the flight path.

To encourage the nanoparticles to settle on the surface of the substrate, it can be brought to an elevated electrical potential. Depending on the method by which the atomic stream is produced, some of the atoms will have become negatively charged by acquiring electrons. Sputter methods are suitable since they Involve the production of a plasma at the surface of the material source, so the nanoparticles to which these atoms contribute will (to an extent) inherit that charge and be attracted to a positively charged substrate.

### SUMMARY OF THE INVENTION

The present Invention seeks to allow sputtering to move towards a more commercial scale, by encouraging the production of the necessary charged nanoparticles, and also by adopting a geometry that is more susceptible to operation on an increased scale.

We have noticed that it Is In fact somewhat rare for certain atoms to emerge in a charged state. This applies particularly to metallic atoms such as Cu which will prefer (if anything) to emerge as Cu⁺ or Cu²⁺ rather than Cu⁻. We have however noticed that a Cuₙ nanoparticle is significantly more willing to accept a single electron - this seems to be a combination of the greater swept volume of the larger entity and a greater willingness of the waveform of the Cuₙ entity to accept an electron. In the first aspect of the present Invention, we therefore propose to Increase the population of charged nanoparticles by providing a plasma or electron cloud in the flight path at a later stage where atoms are more likely to have coalesced into nanoparticles, These charged nanoparticles will then be more willing to come to rest on an appropriately charged substrate, and we have noted a corresponding increase in deposition rate.

Where the atomic stream is produced by a plasma-based method such as sputter evaporation we therefore propose (in one aspect of the invention) the use of magnets to extend the physical extent of the sputter plasma. This in turn provides an extended population of free electrons in a gas condensation zone. This extended population of electrons allows electron capture by the nanoparticles that have been generated by the plasma, The effect of this is to allow almost 100% of the nanoparticles to become charged with at least one additional electron. The deposition rate of charged nanoparticles has then been observed to increase by as much as a factor of ten using a simple experimental set up.

Accordingly, in Its first aspect the present invention provides an apparatus for the production of nanoparticles, comprising a magnetron within a chamber containing a gas at low pressure, a means for creating a flow of the gas away from the magnetron, and at least one source of magnetic flux located downstream from the magnetron.

The source of magnetic flux can be a plurality of permanent magnets or an electromagnet.

The magnetron can be a conventional magnetron, or it can be as described below in relation to the second aspect of the present invention.

In that second aspect, we seek to provide a geometry more susceptible to operation on an Increased scale. Accordingly, we provide a magnetron for sputter deposition comprising a cylindrical target having at least an outer face of the material to be deposited and a hollow interior, and a source of magnetic flux within the hollow interior arranged to present magnetic poles in a direction that is radially outward with respect to the cylindrical target.

Again, the source of magnetic flux can be a plurality of permanent magnets or an electromagnet. Further, the cylindrical target can contain at least one axially-extending conduit for a coolant fluid.

The source of magnetic flux preferably presents a north magnetic pole in a radially outward direction at a plurality of first locations that are circumferentially spaced and axially co-located, and presents a magnetic south pole in a radially outward direction at a plurality of second locations that are circumferentially spaced and axially co-located and which are axially spaced from the first locations. This creates a magnetic field at the target surface that alternates along an axial direction, in which a plasma for sputter deposition can be created. We further prefer that the like poles extend around the complete circumference of the target, thus forming circumferential bands around the target of alternating north and south magnetic poles. We also prefer that the poles alternate many times along the axial length of the target; these arrangements contribute to a greater efficiency of the target.

Generation of nanoparticles by magnetron sputtering followed by gas condensation is itself well known. However there has been no substantial effort to analyse the conditions under which nanoparticles are ionised, gain electrons, or remain neutral. The plasma can be extended by using an 'unbalanced' magnetron, or by using additional magnets, or both. The use of unbalanced magnets is known as such, albeit as a means of Increasing the area of the sputter target that is utilised. It seems that the use of additional magnets to extend the plasma away from the sputter target and/or the use of an unbalanced magnetron in the production of nanoparticles have not been described before.

Where we refer to "magnets" in this application, we intend by this term to mean any source of magnetic flux. This obviously includes permanent magnets, of which there are a wide variety of types, but also includes electromagnets.

### BRIEF DESCRIPTION OF THE DRAWINGS

An embodiment of the present invention will now be described by way of example, with reference to the accompanying figures in which;
Figure 1 shows a schematic view of a magnetron according to the first aspect of the present invention;
Figure 2 shows an axial section through the magnetron of figure 1;
Figure 3 shows a radial section through the magnetron of figure 1;
Figure 4 shows a schematic view of a sputter deposition arrangement incorporating the magnetron of figures 1 to 3;
Figure 5 shows the general layout of a sputter deposition apparatus according to the second aspect of the present invention;
Figure 6 shows a practical arrangement of the apparatus of figure 5; and
Figure 7 shows the effect of the second aspect on the size distribution of nanoparticles produced.

### DETAILED DESCRIPTION OF THE EMBODIMENTS

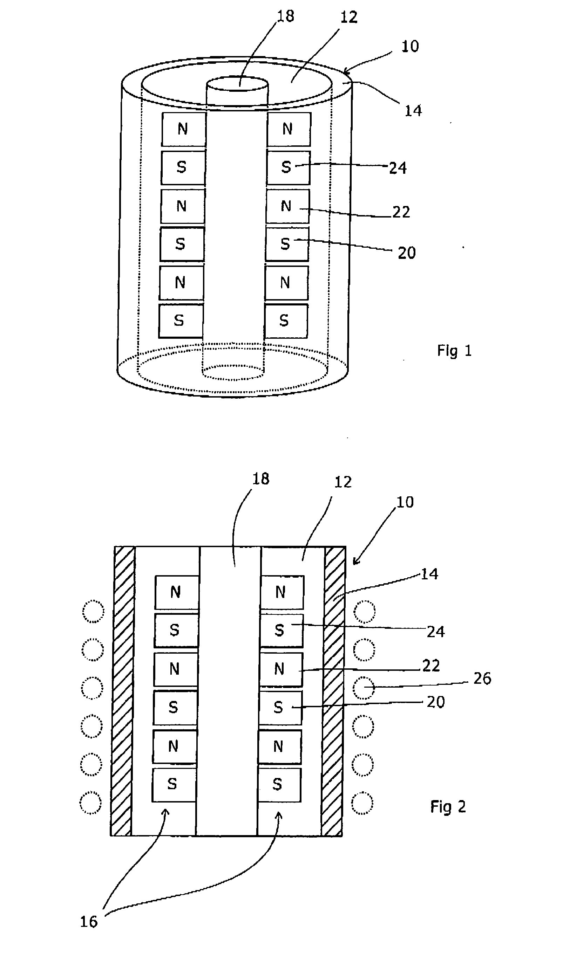

Figures 1 and 2 show a magnetron layout according to the present invention. A target 10 is formed in the shape of a hollow cylinder, with a concentric interior space 12 that leaves an annular section of material 14 to form the target. As illustrated, the target Is a solid annulus of the material to be deposited, but depending on the choice of material it may alternatively be in the form of an inert or substantially inert former carrying an external layer or coating of the material to be deposited.

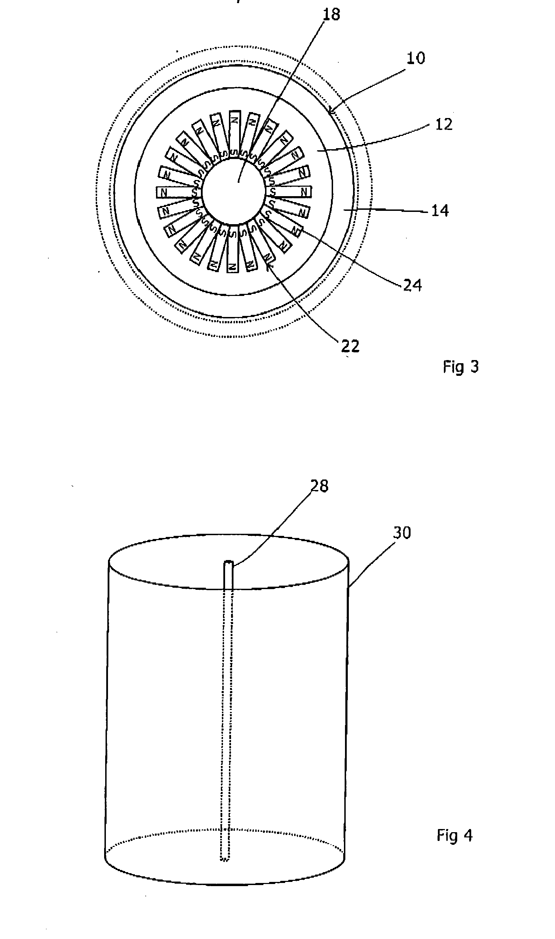

Within the interior space 12, there is an array of permanent magnets 16 to create the necessary magnetic field patterns for sputtering. These are mounted on a centrally-located support 18 and are arranged in a series of axlally-spaced rings 20, 22, 24. Each ring presents an alternating magnetic pole in a radial outward direction; figure 3 shows a single ring 22 of permanent magnets 24, from which is can be seen that the ring consist of a large number of bar magnets all arranged in a radial direction with their South pole (in this case) located proximte the central support 18. This leaves their North poles directed radially outwards. In the rings above 24 and below 20 the ring 22 illustrated in figure 3, the orientations of the magnets 24 are reversed, so that a South pole is directed radially outwardly. Thus, along the axial direction the magnetic pole reverses repeatedly, thereby allowing the production of a localised plasma 26 at locations between each ring 20, 22, 24.

Other arrangements of magnets would of course work, producing differently shaped plasmas.

Such a magnetron can be made in essentially any length desired by duplicating the arrangement shown in figures 1 to 3 the required number of times. Figure 4 shows a long example of such a magnetron 28 mounted centrally in a low pressure chamber 30. Items to be coated can be arrayed around the interior walls of the chamber 30 and the cylindrically symmetric nature of the magnetron 28 will mean that all will be coated. This can be contrasted with known magnetrons which emit a directional flow of material; items to be coated therefore need to be placed within a relatively limited space. The omnidirectional nature of the magnetron 28 allows for a much more efficient usage of the chamber 30.

Other shapes for the chamber 30 could be employed, of course. However, it will generally be preferred for the Items to be coated to be placed symmetrically around the magnetron for obvious reasons.

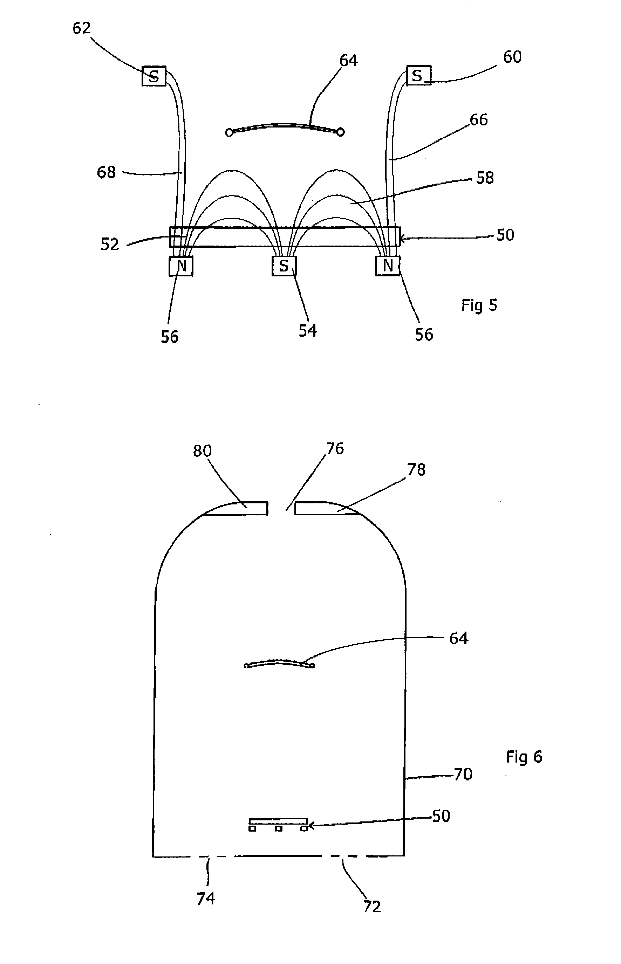

Figure 5 shows an arrangement for producing nanoparticles according to the second aspect of the present invention. As noted above, nanoparticle production generally progresses by the evaporation of atoms from the target surface which then recombine In small numbers to form nanoparticles during the drift from the target to the substrate onto which they will be deposited, To be successful, these particles must actually deposit where needed, so the substrate is generally placed at an elevated electrical potential so as to attract the (generally) negatively charged nanoparticles.

Thus, increasing the proportion of nanoparticles that carry a net negative charge will increase significantly the efficiency of this process simply by attracting more to where they can be harvested. However, this is not straightforward. First, it is in fact somewhat rare for certain atoms to emerge in a negatively charged state, metallic atoms in particular.

Extending the plasma region from the immediate vicinity of the magnetron to cover a significant part of the drift path does however have a significant effect. As the atoms or nanoparticles drift through the plasma, there is of course an ample supply of electrons with which to combine. This, combined with the apparent greater readiness of a nanoparticles to accept an electron as compared to a single atom, means that extending the plasma in this way Is especially beneficial.

Figure 5 shows such an arrangement. An unbalanced magnetron 50 comprises a target 52 over a centrally-located South pole 54 flanked by stronger North poles 56. Thus, a plasma 58 Is formed in the familiar oval "racetrack" configuration. Also shown In figure 5 are a pair of additional South poles 60, 62 located beyond the positively charged grid 64 placed In order to attract negatively charged atoms and particles away from the target 52. These additional poles pick up the excess magnetic flux from the North poles of the unbalanced magnetron 50 and draw the plasma out from the surface of the target to elongate sections 66, 68. This creates an extended volume of plasma as described above.

Figure 6 shows a practical arrangement. The same unbalanced magnetron 50 is located within a low pressure chamber 70 behind the positively charged grid 64. Inlet ports 72, 74 are provided behind the magnetron 50 to allow a gentle flow of gas at low pressure to be established, flowing past the magnetron 50 and towards an outlet 76 at the opposite end of the chamber 70 beyond the grid 64, Sputtered atoms In the flow are encouraged to coalesce Into nanoparticles by collisions with the gas atoms. A plurality of magnets 78, 80 are arranged around the outlet 76 on an inner face of the chamber 70 to pick up the excess magnetic flux of the unbalanced magnetron 50, as described above.

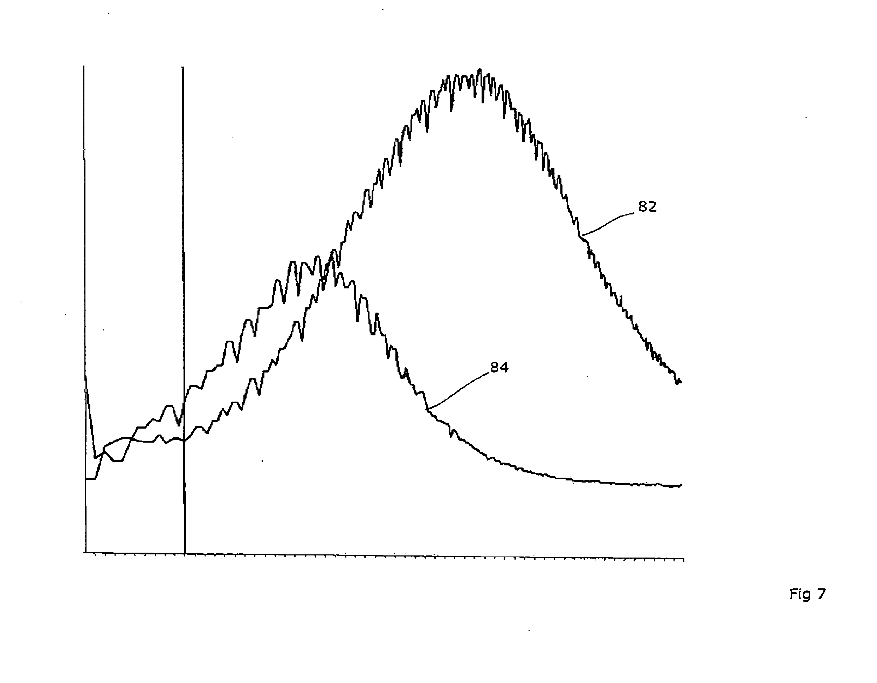

Figure 7 shows the effect of this measure in the form of a graph showing the difference in a copper nanoparticle mass spectrum 82 due to the presence of magnets as shown in figure 6. The lower curve 84 is without magnets. The difference is extremely large when account is taken of the fact that the in larger diameter nanoparticles, the number of atoms increases to the power three. The difference in deposition rate is a factor of about 10.

It will of course be understood that many variations may be made to the above-described embodiment without departing from the scope of the present invention.

## Claims

1. Apparatus for the production of nanoparticles, comprising a magnetron within a chamber containing a gas at low pressure, a means for creating a flow of the gas away from the magnetron, and at least one source of magnetic flux located downstream from the magnetron,

2. Apparatus according to claim 1 in which the source of magnetic flux is a plurality of permanent magnets.

3. Apparatus according to claim 1 in which the source of magnetic flux is an electromagnet.

4. Apparatus according to any one of claims 1 to 3 in which the magnetron comprises a cylindrical target having at least an outer face of the material to be deposited and a hollow interior, and a source of magnetic flux within the hollow interior arranged to present magnetic poles in a direction that Is radially outward with respect to the cylindrical target.

5. Apparatus according to claim 4 in which the source of magnetic flux presents alternating north and south magnetic poles in circumferential bands around the target.

6. Apparatus according to claim 4 or claim 5 in which the source of magnetic flux presents a north magnetic pole in a radially outward direction at a plurality of first locations that are circumferentially spaced and axially co-located, and presents a magnetic south pole in a radially outward direction at a plurality of second locations that are circumferentially spaced and axially co-located and which are axially spaced from the first locations.

7. Apparatus according to any one of claims 4 to 6 In which the target contains at least one axially-extending conduit for a coolant fluid.

8. A magnetron for sputter deposition comprising a cylindrical target having at least an outer face of the material to be deposited and a hollow interior, and a source of magnetic flux within the hollow interior arranged to present magnetic poles in a direction that is radially outward with respect to the cylindrical target.

9. A magnetron according to claim 8 in which the source of magnetic flux is a plurality of permanent magnets.

10. A magnetron according to claim 8 in which the source of magnetic flux Is an electromagnet.

11. A magnetron according to any one of claims 8 to 10 in which the source of magnetic flux presents alternating north and south magnetic poles in circumferential bands around the target.

12. A magnetron according to any one of claims 8 to 11 in which the source of magnetic flux presents a north magnetic pole in a radially outward direction at a plurality of first locations that are circumferentlally spaced and axially co-located, and presents a magnetic south pole in a radially outward direction at a plurality of second locations that are circumferentially spaced and axially co-located and which are axially spaced from the first locations.

13. A magnetron according to any one of claims 8 to 12 in which the target contains at least one axially-extending conduit for a coolant fluid.
